# EUROPEAN PATENT APPLICATION

(11) **EP 4 439 869 A1**
(43) Date of publication of application: **02.10.2024**
(21) Application number: 23205977.4
(22) Date of filing: 26.10.2023
(51) Int. Cl.: H01R 12/58, H01R 43/16

(54) **A METAL STRIP HAVING CONTINUOUS SOLDERLESS TERMINALS, AND ITS MANUFACTURING METHOD, PCB AND INSERTION METHOD**

(30) Priority: 30.03.2023 CN 202310336690
(71) Applicant: Axon' Interconnect Ltd, Foshan Guangdong 528306 (CN)
(72) Inventor: GAO, Ronghua, Foshan, 528306 (CN); LOW, SEAN CHEANG, Foshan, 528306 (CN); JACOBS, GUILLAUME, Foshan, 528306 (CN); GE, Yunqiu, Foshan, 528306 (CN); CHEN, Zhiyi, Foshan, 528306 (CN)
(74) Representative: Cabinet Chaillot

(57) **Abstract**

The present invention relates to a metal strip having continuous solderless terminals (2), including a copper strip (1) having a tin plated surface layer and a silver plated bottom layer, wherein the copper strip (1) is stamped with a plurality of solderless terminals (2) along its length direction; each solderless terminal (2) is, from top to bottom, sequentially provided with a guiding head section (3), a fisheye shaped section (4), and a tail section (5); the fisheye shaped section (4) is along its length direction provided with tear holes (6) that form a deformation space on the outer wall of the fisheye shaped section (4); the tail section (5) of the front solderless terminal (2) is connected to the guiding head section (3) of the rear solderless terminal (2); a connection area (7) is formed at the connection, and a notch (71) that facilitates the separation of the front solderless terminal (2) and the rear solderless terminal (2) is stamped in the connection area (7); the users can separate and insert the solderless terminals (2) of the copper strip (1) into the corresponding jacks (81) of the printed circuit board using a pin insertion device, which is solderless and convenient for customers to use; the fisheye shaped section (4) with tear holes (6) in the solderless terminal (2) can greatly meet the demand for insertion and extraction force.

## Description

### Technical Field

The present invention relates to the field of electrical connection technology, in particular to the metal strips with continuous solderless terminals, the manufacturing methods for metal strips with continuous solderless terminals, methods for inserting solderless terminals of metal strips into PCB, and to the PCB using metal strips with continuous solderless terminals.

### Background Art

Currently, a variety of power conversion modules are commonly applied in new energy vehicles, and terminals are used on the power conversion module to connect the DBC substrate at the bottom of the module and the PCB at the top of the module. Typically, the terminals of this type of product are connected using square straight pins or stamped connectors.

When a square straight pin is used, one end of the square straight pin is inserted into a cylindrical solder pad with a hole slot on the bottom DBC substrate for tight fitting fixation, and the other end is inserted into the solder pad on the top PCB of the module for welding fixation.

In the case of stamped connectors, one end of the connector is directly welded to the bottom DBC substrate, and the top is welded or directly inserted into the PCB hole for fixation.

Since terminals are a type of accessory product related to the field of electrical connection technology, they are classified into the category of connectors in industry. With the advancement of industrial automation and the higher requirement for connection accuracy, terminals have seen more and more diverse types and widespread applications. Terminals usually include wiring terminals, hardware terminals, PCB plug terminals, connector plug terminals, etc.

Disadvantages of straight pin: the terminals that are welded through straight pin insertion can be connected to the PCB through-hole through welding only, which increases a welding step. The solder welding may lead to a risk of false soldering during vibration.

A type of stamped fisheye terminal is also available. Since the flat copper strip is stamped by a stamping equipment, the flat metal copper strip is cut by the stamping mold on the stamping equipment and and then stamped and formed according to the shape of fisheye terminal, this will result in significant waste of leftover materials during the stamping process, and except for the terminals which are the required products, other parts of the flat copper strip are regarded and handled as leftover materials.

### Summary of the Invention

The first purpose of the present invention is to provide a metal strip having continuous solderless terminals that reduces the leftover materials generated, saves costs, and meets the requirements of press-in and push-out force.

The second purpose of the present invention is to provide a simple and efficient manufacturing method for producing metal strips with continuous solderless terminals.

The third purpose of the present invention is to provide a method for inserting solderless terminals on PCBs using simple and solderless metal strips.

The fourth purpose of the present invention is to provide a PCB with a metal strip having continuous solderless terminals that are solderless and securely inserted.

The first purpose of the present invention is achieved as follows:
A metal strip having continuous solderless terminals, including a copper strip having a tin plated surface layer and a silver plated bottom layer, wherein the copper strip is stamped with a plurality of solderless terminals along its length direction;
each solderless terminal is, from top to bottom, sequentially provided with a guiding head section, a fisheye shaped section, and a tail section; the fisheye shaped section is along its length direction provided with tear holes that form a deformation space on the outer wall of the fisheye shaped section;
the tail section of the front solderless terminal is connected to the guiding head section of the solderless terminal behind; a connection area is formed at the connection, and a notch that facilitates the separation of the front solderless terminal and the rear solderless terminal is stamped in the connection area.

The copper strip is stamped with a fisheye shaped section by a tool specific for pin device, at the same time, a plurality of solderless terminals are connected from end to end, forming a connection area at their joint; the connection area is stamped with a notch that is easy to separate the front solderless terminal from the rear solderless terminal, making it easy to separate the solderless terminal and avoiding the waste of a large amount of materials caused by conventional flat copper strip stamping methods; in addition, a plurality of solderless terminals form copper strips that can be rolled up for easy transportation; the users who intend to use solderless terminals can separate and insert the solderless terminals of the copper strip into the corresponding jacks of the printed circuit board (PCB) using a pin insertion device, which is solderless and convenient for customers to use; moreover, the fisheye shaped section with tear holes in the solderless terminal can greatly meet the demand for insertion and extraction force, and provide reliable insertion.

The first purpose of the present invention can also be addressed by the following technical measures:
In further, the guiding head section is a strip with an upper sharp corner, the tail section is a strip with a lower sharp corner, and the upper sharp corner of the guiding head section of the front solderless terminal and the lower sharp corner of the tail section of the rear solderless terminal are connected to form a notch, and the angle between the upper sharp corner and lower sharp corner is 45+/-15 degrees.

The front solderless terminal and the rear solderless terminal are connected end-to-end to form a metal strip; the metal strip can be rolled onto a reel to facilitate the transportation of solderless terminal, and a notch is formed at the connection joint between the front solderless terminal and the rear solderless terminal and, then the metal strip is fed into the slitting and pin insertion device; due to the presence of the notch, the slitting and pin insertion device can easily separate the solderless terminal, and moreover, the slitting and pin insertion function devices simultaneously insert the separated solderless terminals into the jacks of the PCB, making the insertion simple and fast.

In further, the fisheye shaped section is divided from top to bottom along its length direction into a guiding fisheye head section, a deformation retaining region section, and a fisheye tail section; the guiding head section is connected to the guiding fisheye head section, and the tail section is connected to the fisheye tail section.

The guiding head section aligns the solderless terminal with the jack of the PCB, and then smoothly guides the fisheye shaped section into the jack of the PCB with minimal resistance through the guiding fisheye head section; the guiding fisheye head section is also a transitional buffer zone and when the solderless terminal is completely inserted into the jack of the PCB, since the diameter of the jack is smaller than the width of the fisheye shaped section, the fisheye shaped section will undergo force deformation during the insertion process, and the main force-bearing position is the deformation retaining area section; after full insertion into the jack of the PCB and being positioned in the deformation retaining section, the solderless terminal will exert force on the jack of the PCB due to deformation, resulting in a certain retention force between the solderless terminal and the PCB; in this way, the solderless terminal can be physically connected with the metal layer of the jack of PCB through elasticity or stress to realize electric conduction; replacing conventional welding terminals with solderless terminals can eliminate the welding process to greatly improve production efficiency. However, since the shape of solderless terminals is directly related to the insertion and retention force of the jack of the PCB, as well as the elastic deformation after insertion, the design of fisheye shaped section is the key point. The fisheye shaped section designed in the present invention provides guiding effect and easy insertion when when the solderless terminal is inserted, and can eliminate the welding process and greatly improve the production efficiency when the fisheye shaped section of the solderless terminal is inserted into the jack of PCB through interference fit for tight clamping.

In further, the fisheye shaped section includes a V-shaped head, a strip-shaped body, and a V-shaped tail; the upper end of the strip-shaped body is connected to the V-shaped head, and the lower end of the strip-shaped body is connected to the V-shaped tail to form the fisheye shaped section, the strip-shaped body is along its length direction provided with a tear hole that connects the V-shaped head and V-shaped tail; the V-shaped head forms the guiding fisheye head section, and the V-shaped tail forms the fisheye tail section.

In further, the length of the fisheye shaped section is 2.5+/-0.8mm, the width of the fisheye shaped section is 1.2+/-0.05mm, and the thickness of the fisheye shaped section is 0.635+/-0.04mm.

The PCB in the present invention is provided with jacks having an aperture ranging from 0.90mm to 1.10mm, and the width of the fisheye shaped section of solderless terminal is 1.2+/-0.05mm, and when the fisheye shaped section of the solderless terminal is inserted into the jack of the PCB, tear holes occur to the fisheye shaped section since the width of the fisheye shaped section is greater than the aperture of the jack; the interference fit between the fisheye shaped section and the jack generates rebound stress, so that the solderless terminal can realize electric conduction by means of physical connection with the metal layer of the jack of PCB through elasticity or stress, and provide reliable and solderless insertion and higher production efficiency.

In further, the length of the guiding fisheye head section is 0.60+/-0.2mm, the length of the fisheye tail section is 0.50+/-0.2mm, and the length of the deformation retaining area section is 1.5+/-0.5mm.

In further, the length of the tear hole is 1.5+/-0.50mm, and the width of the tear hole is 0.2+/-0.10mm.

The length and width of a tear hole can be restricted to limit its deformation space, ensuring that the press-in force of the solderless terminal does not exceed N, and the push-out force of the solderless terminal is greater than N, so that the solderless terminal can realize electric conduction by means of physical connection with the metal layer of the jack of PCB through elasticity or stress, and provide reliable and solderless insertion and higher production efficiency. The second purpose of the present invention is realized as follows:
A method for manufacturing a metal strip having continuous solderless terminals, including the following steps:
Step 1: Use a square pre-plated copper strip having tin-plated surface and silver-plated bottom;
Step 2: Feed the copper strip into a stamping equipment, which includes a first stamping component for stamping the notch and fisheye shaped section, and a second stamping component for trimming the fisheye shaped section;
Step 3: The first stamping component stamps fisheye shaped sections and notches along the length direction of the copper strip, thereby stamping a plurality of solderless terminals out of the copper strip;
Step 4: The second stamping component stamps a tear hole in the direction perpendicular to the fisheye shaped section, while the second stamping component adjusts the width of the fisheye shaped section by stamping in the direction parallel to the fisheye shaped section, thereby adjusting the shape of the fisheye shaped section;
Step 5: Feed the copper strip mentioned in step 4 into the winding device, which rolls the copper strip into the winding shaft.

The copper strip is placed into the stamping device in the above method, and the first stamping component of the stamping device stamps fisheye shaped sections and notches, thereby stamping the copper strip into a plurality of solderless terminals that are connected end-to-end, and the notches facilitate the separation of the solderless terminals that are connected end-to-end; the second stamping component of the stamping device reshapes and adjusts the fisheye shaped sections to ensure that each solderless terminal has the fisheye shape sections of the same shape, and also ensure the qualification rate of the solderless terminal.

The third purpose of the present invention is realized as follows:
A method for inserting solderless terminals of metal strips onto a PCB, including the following steps:
Step 1: Feed the metal strip into the device with slitting and pin function, and the device with slitting and pin function will separate the previous solderless terminal and the rear solderless terminal;
Step 2: Feed the PCB into a device with slitting and pin insertion function which will insert the solderless terminal into the corresponding jack of the PCB until the fisheye shaped section of the solderless terminal is placed in the jack through interference fit, and the outer wall of the fisheye shaped section is firmly pressed against the inner wall of the jack, and it is ensured that the press-in force and push-out force of the solderless terminal of the device with slitting and pin insertion function do not exceed 150N and 20N, respectively.

The metal strip is fed into the device with slitting and pin insertion function in the above method; the device with slitting and pin insetion function first separates the front solderless terminal from the rear solderless terminal, and then inserts the solderless terminal into the corresponding jack of the PCB until the fisheye shaped section of the solderless terminal is placed in the jack in an interference fit manner, so that the solderless terminal and the PCB are securely clamped and fixed in a simple and reliable way.

The fourth purpose of the present invention is realized as follows:
A PCB using a metal strip having continuous solderless terminals, wherein the PCB is provided with a jack with an aperture of 0.90mm to 1.10mm, the guiding head section of the solderless terminal passes through the jack, and the fisheye shaped section of the solderless terminal is positioned in the jack through interference fit, and the outer wall of the fisheye shaped section is firmly pressed against the inner wall of the jack.

The PCB in the present invention is provided with jacks having an aperture ranging from 0.90mm to 1.10mm, and the width of the fisheye shaped section of solderless terminal is 1.2+/-0.05mm, and when the fisheye shaped section of the solderless terminal is inserted into the jack of the PCB, tear holes occur to the fisheye shaped section since the width of the fisheye shaped section is greater than the aperture of the jack; the interference fit between the fisheye shaped section and the jack generates rebound stress, so that the solderless terminal can realize electric conduction by means of physical connection with the metal layer of the jack of PCB through elasticity or stress, and provide reliable and solderless insertion and higher production efficiency.

The beneficial effects of the present invention are as follows:
In the present invention, the copper strip is stamped with a fisheye shaped section by a tool specific for pin device, at the same time, a plurality of solderless terminals are connected from end to end, forming a connection area at their joint; the connection area is stamped with a notch that is easy to separate the front solderless terminal from the rear solderless terminal, making it easy to separate the solderless terminal and avoiding the waste of a large amount of materials caused by conventional flat copper strip stamping methods; in addition, a plurality of solderless terminals form copper strips that can be rolled up for easy transportation; the users who intend to use solderless terminals can separate and insert the solderless terminals of the copper strip into the corresponding jacks of the printed circuit board using a pin insertion device, which is solderless and convenient for customers to use; moreover, the fisheye shaped section with tear holes in the solderless terminal can greatly meet the demand for insertion and extraction force, and provide reliable insertion.

In the present invention, the front solderless terminal and the rear solderless terminal are connected end-to-end to form a metal strip; the metal strip can be rolled onto a reel to facilitate the transportation of solderless terminal, and a notch is formed at the connection joint between the front solderless terminal and the rear solderless terminal and, then the metal strip is fed into the slitting and pin insertion device; due to the presence of the notch, the slitting and pin insertion device can easily separate the solderless terminal, and moreover, the slitting and pin insertion function devices simultaneously insert the separated solderless terminals into the jacks of the PCB, making the insertion simple and fast.

In the present invention, the guiding head section aligns the solderless terminal with the jack of the PCB, and then smoothly guides the fisheye shaped section into the jack of the PCB with minimal resistance through the guiding fisheye head section; the guiding fisheye head section is also a transitional buffer zone and when the solderless terminal is completely inserted into the jack of the PCB, since the diameter of the jack is smaller than the width of the fisheye shaped section, the fisheye shaped section will undergo force deformation during the insertion process, and the main force-bearing position is the deformation retaining area section; after full insertion into the jack of the PCB and being positioned in the deformation retaining section, the solderless terminal will exert force on the jack of the PCB due to deformation, resulting in a certain retention force between the solderless terminal and the PCB; in this way, the solderless terminal can be physically connected with the metal layer of the jack of PCB through elasticity or stress to realize electric conduction; replacing conventional welding terminals with solderless terminals can eliminate the welding process to greatly improve production efficiency. However, since the shape of solderless terminals is directly related to the insertion and retention force of the jack of the PCB, as well as the elastic deformation after insertion, the design of fisheye shaped section is the key point. The fisheye shaped section designed in the present invention provides guiding effect and easy insertion when when the solderless terminal is inserted, and can eliminate the welding process and greatly improve the production efficiency when the fisheye shaped section of the solderless terminal is inserted into the jack of PCB through interference fit for tight clamping.

In the present invention, the PCB is provided with jacks having an aperture ranging from 0.90mm to 1.10mm, and the width of the fisheye shaped section of solderless terminal is 1.2+/-0.05mm, and when the fisheye shaped section of the solderless terminal is inserted into the jack of the PCB, tear holes occur to the fisheye shaped section since the width of the fisheye shaped section is greater than the aperture of the jack; the interference fit between the fisheye shaped section and the jack generates rebound stress, so that the solderless terminal can realize electric conduction by means of physical connection with the metal layer of the jack of PCB through elasticity or stress, and provide reliable and solderless insertion and higher production efficiency.

In the present invention, the copper strip is placed into the stamping device in the above method, and the first stamping component of the stamping device stamps fisheye shaped sections and notches, thereby stamping the copper strip into a plurality of solderless terminals that are connected end-to-end, and the notches facilitate the separation of the solderless terminals that are connected end-to-end; the second stamping component of the stamping device reshapes and adjusts the fisheye shaped sections to ensure that each solderless terminal has the fisheye shape sections of the same shape, and also ensure the qualification rate of the solderless terminal.

In the present invention, the metal strip is fed into the device with slitting and pin insertion function in the above method; the device with slitting and pin insetion function first separates the front solderless terminal from the rear solderless terminal, and then inserts the solderless terminal into the corresponding jack of the PCB until the fisheye shaped section of the solderless terminal is placed in the jack in an interference fit manner, so that the solderless terminal and the PCB are securely clamped and fixed in a simple and reliable way.

### Brief Description of the Drawings

FIG. 1 is a schematic diagram of a metal strip having continuous solderless terminals.
FIG. 2 is the main view of a metal strip having continuous solderless terminals.
FIG. 3 is an enlarged view of Part C of FIG. 2.
FIG. 4 is the A-A cross-sectional view of FIG. 2.
FIG. 5 is the B-B cross-sectional view of FIG. 2.
FIG. 6 is an enlarged view of Part D of FIG.2.
FIG. 7 is the E-E cross-sectional view of FIG.2.
FIG. 8 is a schematic diagram of solderless terminals.
FIG.9 is a schematic diagram of the jack for inserting solderless terminals into the PCB.
FIG. 10 is the F-F cross-sectional view of FIG.9.
FIG. 11 is a schematic diagram of a continuous solderless terminal with a metal strip rolled onto a reel.
FIG. 12 is a test data diagram of the press-in force and push-out force of the solderless terminal (corresponding to the solderless terminal having fisheye shaped sections of different widths when the jack diameter of the PCB is 0.95mm or 1mm).
FIG. 13 is a test data diagram of the press-in force and push-out force of the solderless terminal (corresponding to the solderless terminal having fisheye shaped sections of different widths when the jack diameter of the PCB is 1.05mm).
FIG. 14 is a test data diagram of the press-in force and push-out force of the solderless terminal (corresponding to the solderless terminal having fisheye shaped sections of different widths when the jack diameter of the PCB is 0.95mm or 1mm).
FIG. 15 is a test data diagram of the press-in force and push-out force of the solderless terminal (corresponding to the solderless terminal having fisheye shaped sections of different widths when the jack diameter of the PCB is 1.05mm or 1.1mm).

### Detailed Description of Embodiments

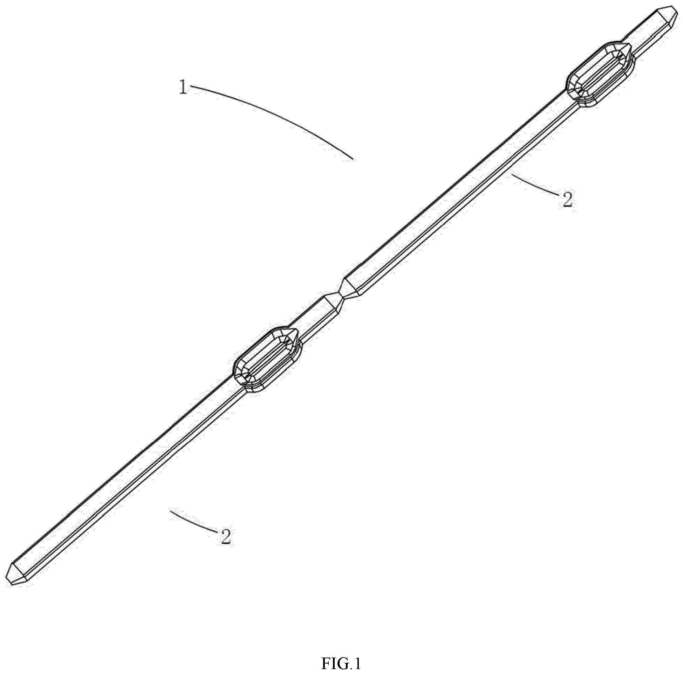

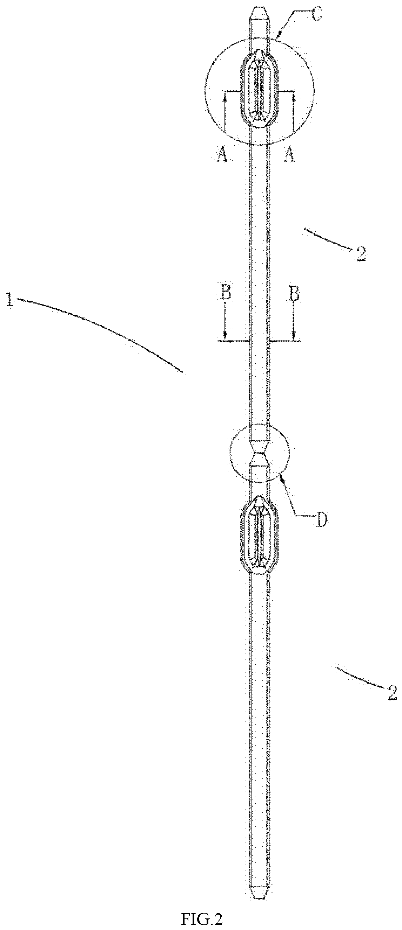

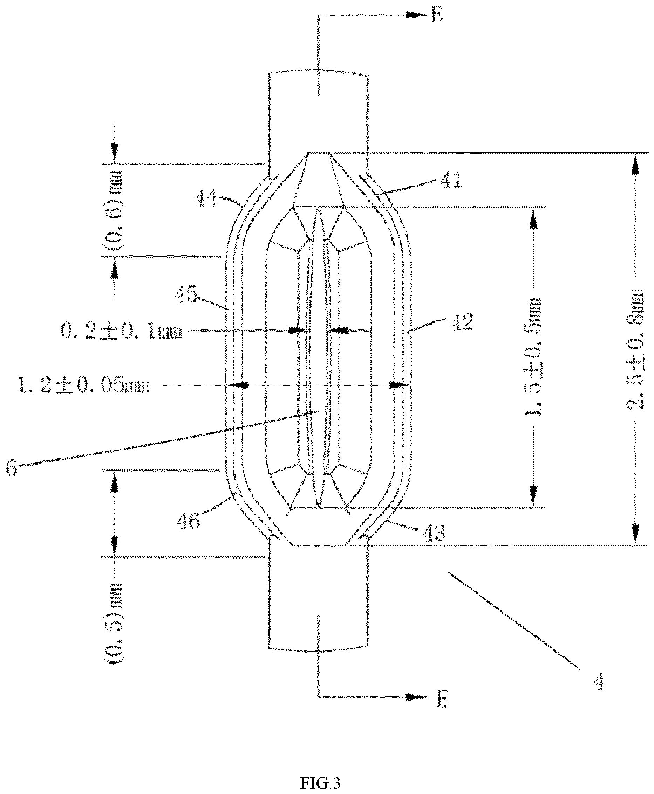

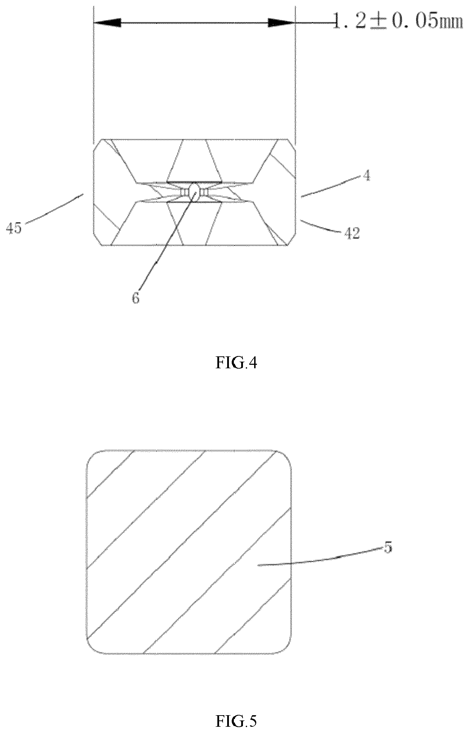

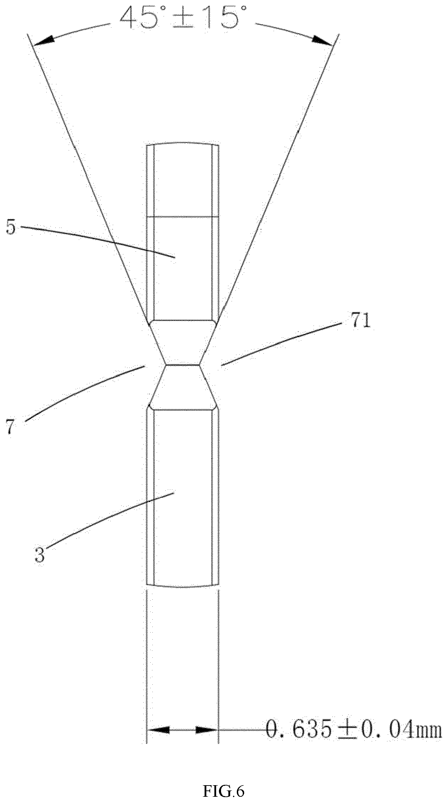

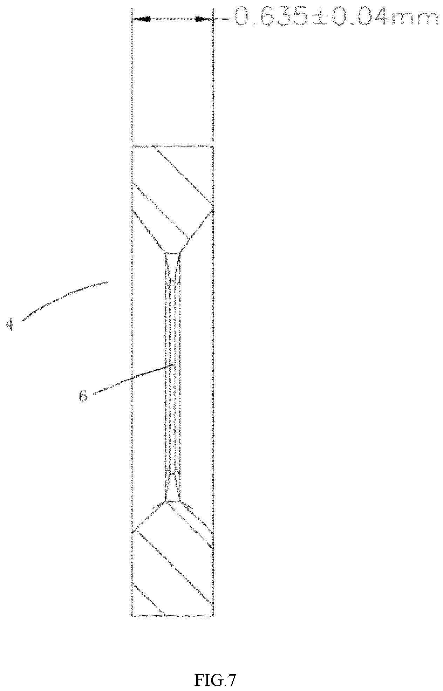

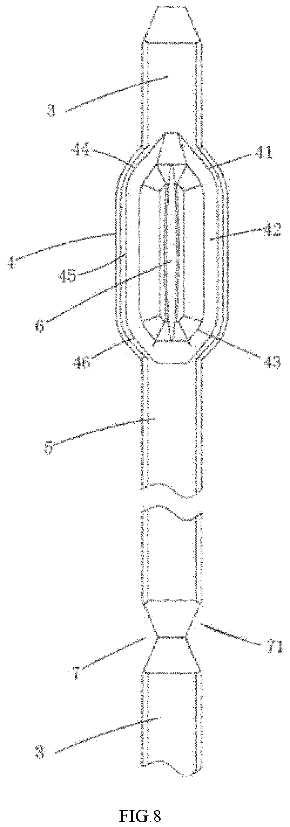

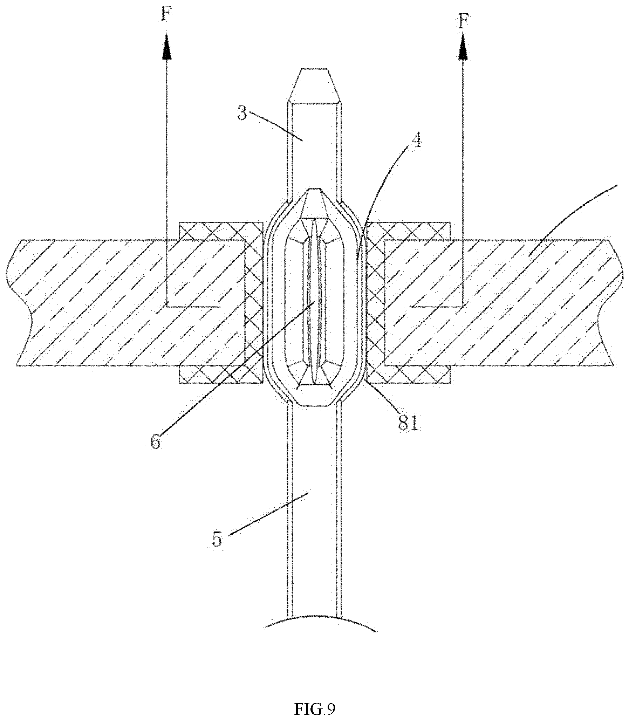

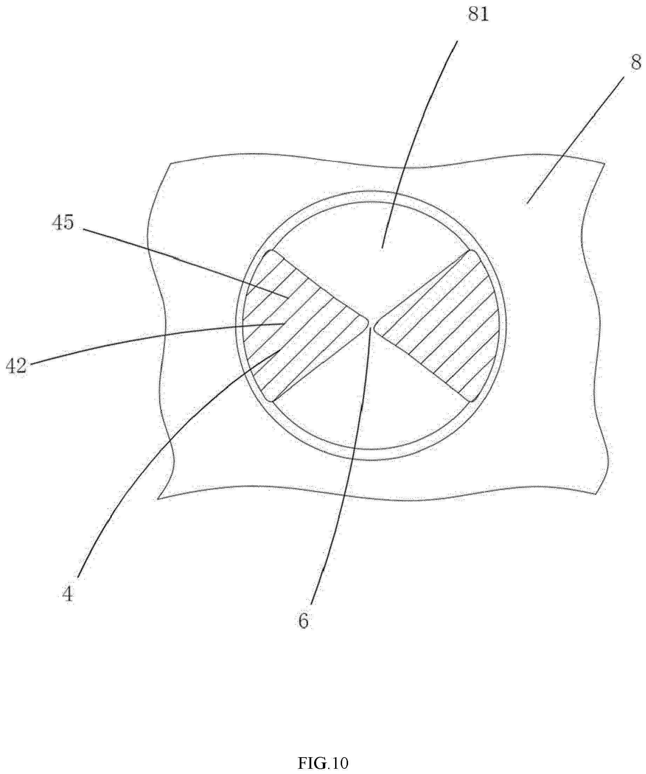

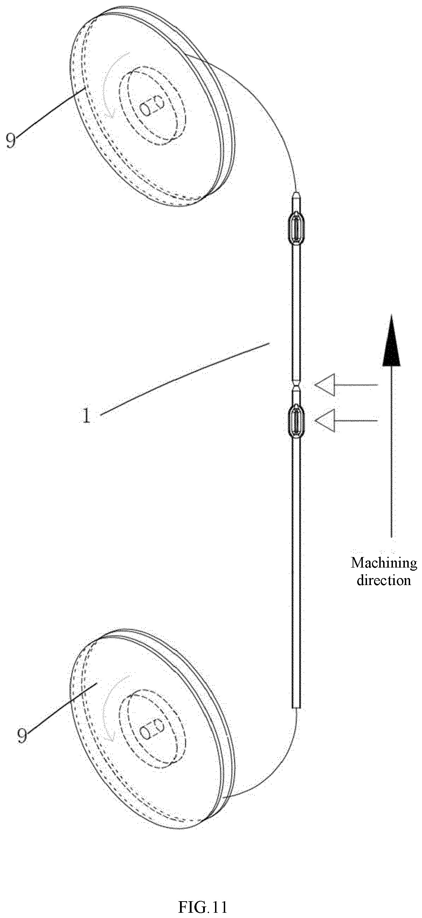

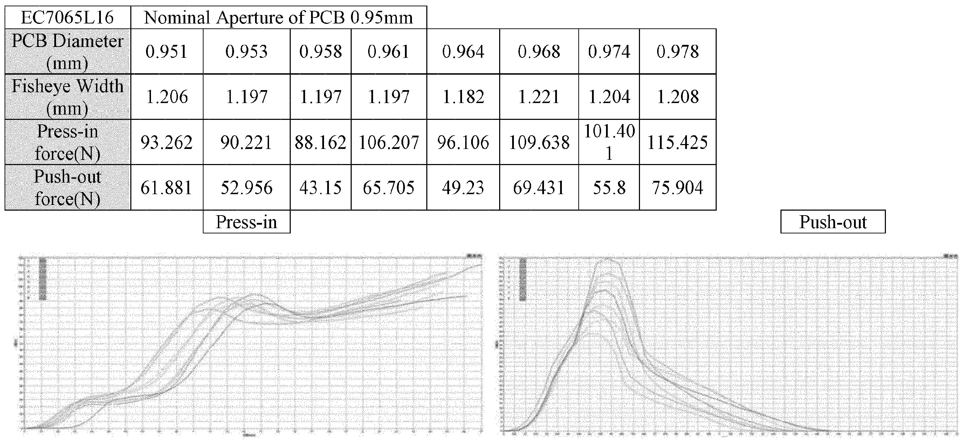

The present invention will be further described in conjunction with the accompanying drawings and embodiments:
in the embodiment, as shown in FIG. 1 to 12, a metal strip having continuous solderless terminals 2 includes a copper strip 1 having a tin-plated surface and a silver-plated bottom, and the copper strip 1 stamps a plurality of solderless terminals 2 along its length direction;
each solderless terminal 2 is, from top to bottom, sequentially provided with a guiding head section 3, a fisheye shaped section 4, and a tail section 5; the fisheye shaped section 4 is along its length direction provided with tear holes 6 that form a deformation space on the outer wall of the fisheye shaped section 4;
the tail section 5 of the front solderless terminal 2 is connected to the guiding head section 3 of the rear solderless terminal 2; a connection area 7 is formed at the connection joint, and a notch 71 that facilitates the separation of the front solderless terminal 2 and the rear solderless terminal 2 is stamped in the connection area 7.

In further, the guiding head section 3 is a strip with an upper sharp corner, the tail section 5 is a strip with a lower sharp corner, and the upper sharp corner of the guiding head section 3 of the front solderless terminal 2 and the lower sharp corner of the tail section 5 of the rear solderless terminal 2 are connected to form a notch 71, and the angle between the upper sharp corner and lower sharp corner is 45+/-15 degrees.

In further, the fisheye shaped section 4 is divided from top to bottom along its length direction into a guiding fisheye head section 41, a deformation retaining region section 42, and a fisheye tail section 43; the guiding head section 3 is connected to the guiding fisheye head section 41, and the tail section 5 is connected to the fisheye tail section 43.

In further, the fisheye shaped section 4 includes a V-shaped head 44, a strip-shaped body 45, and a V-shaped tail 46; the upper end of the strip-shaped body 45 is connected to the V-shaped head 44, and the lower end of the strip-shaped body 45 is connected to the V-shaped tail 46 to form the fisheye shaped section 4, the strip-shaped body 45 is along its length direction provided with a tear hole 6 that connects the V-shaped head 44 and V-shaped tail 46; the V-shaped head 44 forms the guiding fisheye head section 41, and the V-shaped tail 46 forms the fisheye tail section 43.

In further, the length of the fisheye shaped section 4 is 2.5mm, the width of the fisheye shaped section 4 is 1.2mm, and the thickness of the fisheye shaped section 4 is 0.635mm.

In further, the length of the guiding fisheye head section 41 is 0.60mm, the length of the fisheye tail section 43 is 0.50mm, and the length of the deformation retaining area section 42 is 1.5mm.

In further, the length of the tear hole 6 is 1.5mm, and the width of the tear hole is 0.2mm.

A method for manufacturing a metal strip having continuous solderless terminals 2, including the following steps:
Step 1: Use a square pre-plated copper strip 1 having tin-plated surface and silver-plated bottom;
Step 2: Feed the copper strip 1 into a stamping equipment, which includes a first stamping component for stamping the notch 71 and fisheye shaped section 4, and a second stamping component for trimming the fisheye shaped section 4;
Step 3: The first stamping component stamps fisheye shaped sections 4 and notches 71 along the length direction of the copper strip 1, thereby stamping a plurality of solderless terminals 2 out of the copper strip 1;
Step 4: The second stamping component stamps a tear hole 6 in the direction perpendicular to the fisheye shaped section 4, while the second stamping component adjusts the width of the fisheye shaped section 4 by stamping in the direction parallel to the fisheye shaped section 4, thereby adjusting the shape of the fisheye shaped section 4;
Step 5: Feed the copper strip 1mentioned in step 4 into the winding device, which rolls the copper strip 1 into the winding shaft 9.

A method for inserting solderless terminals 2 of metal strips onto a PCB 8, including the following steps:
Step 1: Feed the metal strip into the device with slitting and pin function, and the device with slitting and pin function will separate the previous solderless terminal 2 and the rear solderless terminal 2;
Step 2: Feed the PCB 8 into a device with slitting and pin insertion function which will insert the solderless terminal 2 into the corresponding jack 81 of the PCB 8 until the fisheye shaped section 4 of the solderless terminal 2 is placed in the jack through interference fit, and the outer wall of the fisheye shaped section 4 is firmly pressed against the inner wall of the jack 81, and it is ensured that the press-in force and push-out force of the solderless terminal 2 of the device with slitting and pin insertion function do not exceed 150N and 20N, respectively.

A PCB 8 using a metal strip with a continuous solderless terminal 2, including a PCB 8 that has a jack 81 with an aperture of 0.95mm, and the guiding head section 3 of the solderless terminal 2 passes through the jack 81, the fisheye shaped section 4 of the solderless terminal 2 is placed in the jack 81 through interference fit, and the outer wall of the fisheye shaped section 4 is firmly pressed against the inner wall of the jack 81.

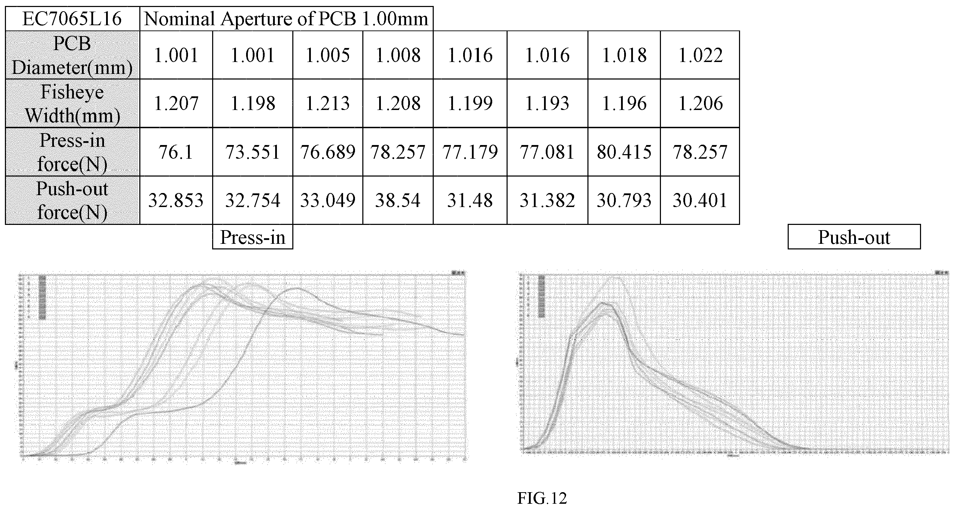

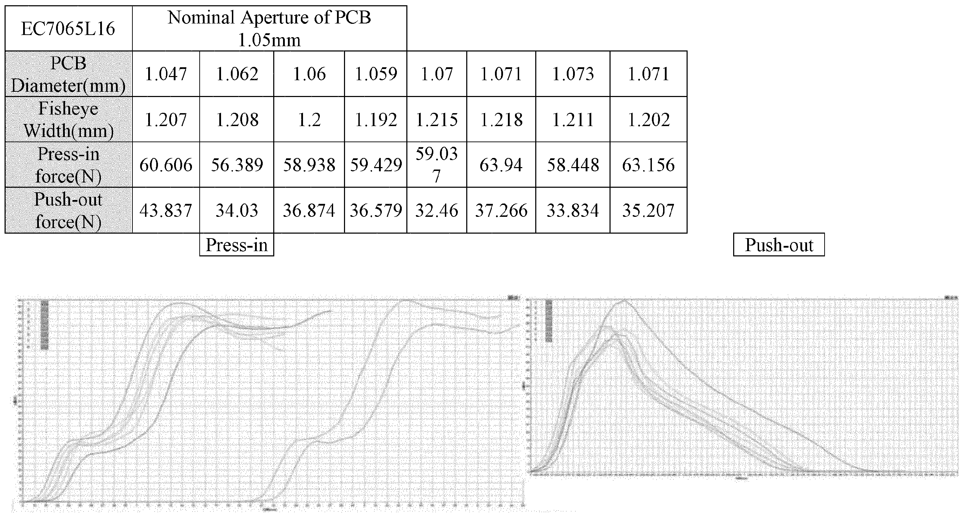

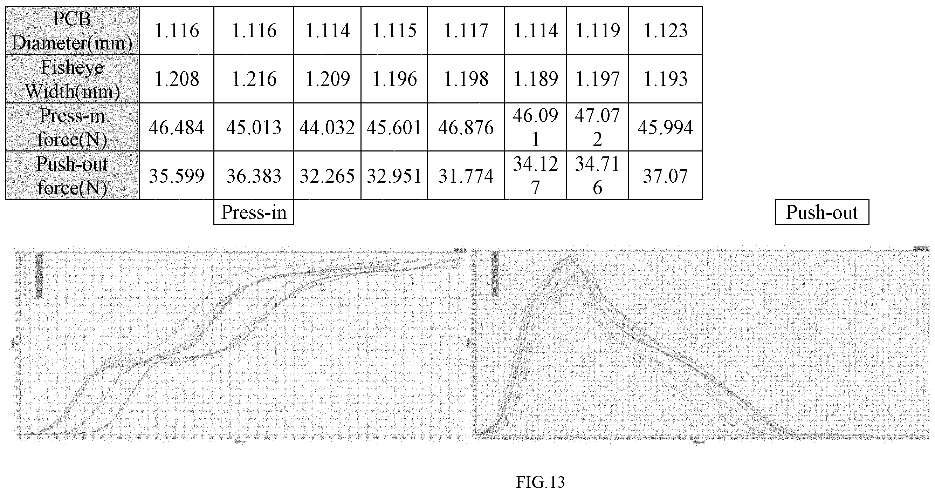

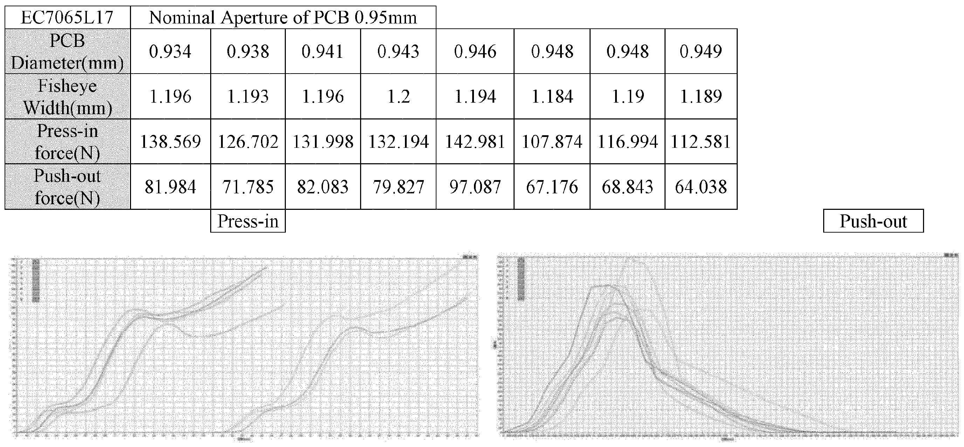

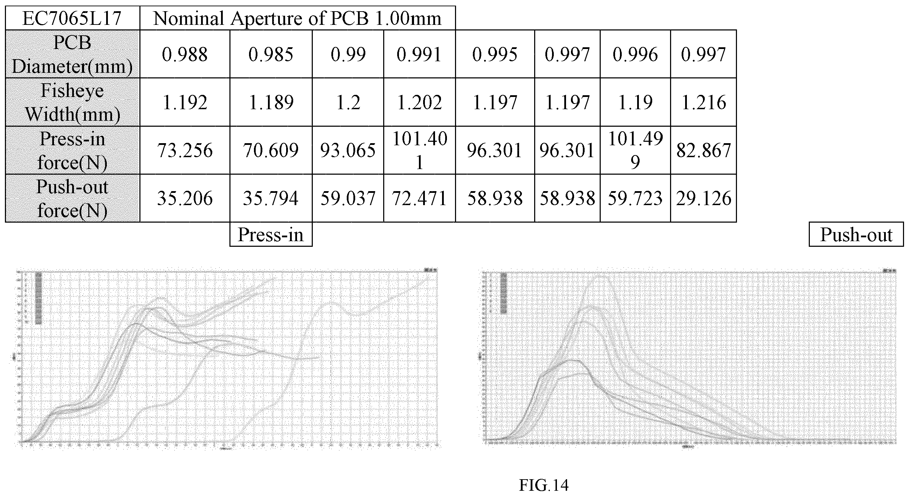

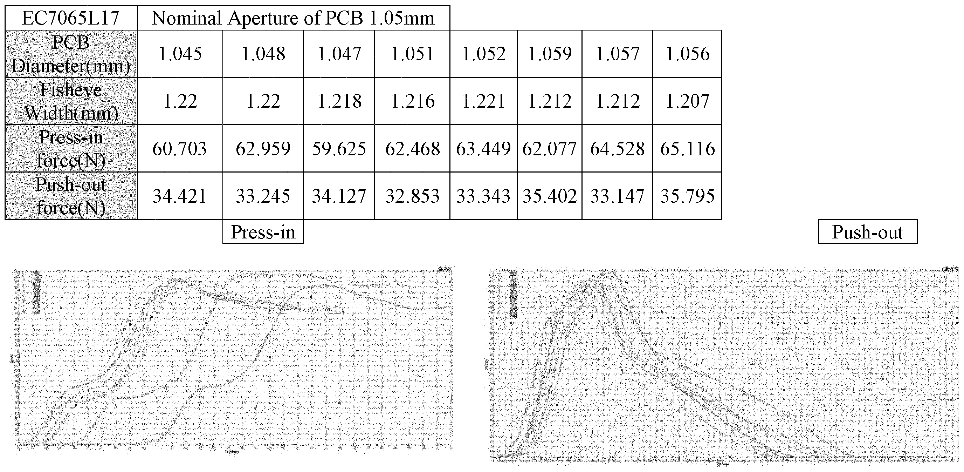

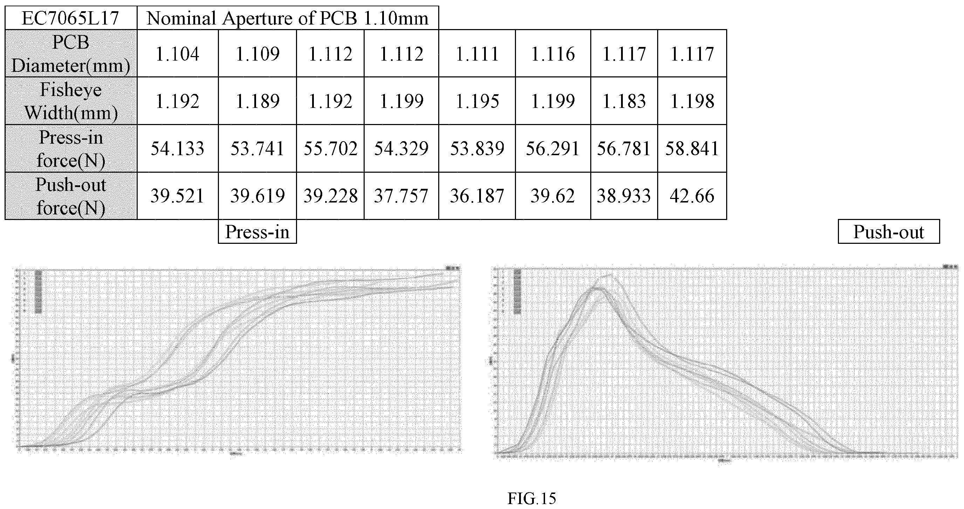

FIG. 12 to 15 above present the test data on press-in force and push-out force of the fisheye shape section corresponding to the solderless terminal with different widths when the PCB has the jacks with an aperture of 0.95mm, 1mm, 1.05mm, and 1.1mm. The test data reveals that the solderless terminal 2 of the present invention is firmly clamped with the jack 81 of the corresponding PCB 8.

## Claims

1. A metal strip having continuous solderless terminals, including a copper strip (1) having a tin plated surface layer and a silver plated bottom layer, wherein the copper strip (1) is stamped with a plurality of solderless terminals along its length direction (2);
each solderless terminal (2) is, from top to bottom, sequentially provided with a guiding head section (3), a fisheye shaped section (4), and a tail section (5); the fisheye shaped section (4) is along its length direction provided with tear holes (6) that form a deformation space on the outer wall of the fisheye shaped section (4);
the tail section (5) of the front solderless terminal (2) is connected to the guiding head section (3) of the solderless terminal (2) behind; a connection area (7) is formed at the connection, and a notch (71) that facilitates the separation of the front solderless terminal (2) and the rear solderless terminal (2) is stamped in the connection area (7).

2. The metal strip having continuous solderless terminals according to claim 1, wherein the guiding head section (3) is a strip with an upper sharp corner, the tail section (5) is a strip with a lower sharp corner, and the upper sharp corner of the guiding head section (3) of the front solderless terminal (2) and the lower sharp corner of the tail section (5) of the rear solderless terminal (2) are connected to form a notch (71), and the angle between the upper sharp corner and lower sharp corner is 45+/-15 degrees.

3. The metal strip having continuous solderless terminals according to claim 1, wherein the fisheye shaped section (4) is divided from top to bottom along its length direction into a guiding fisheye head section (41), a deformation retaining region section (42), and a fisheye tail section (43); the guiding head section (3) is connected to the guiding fisheye head section (41), and the tail section (5) is connected to the fisheye tail section (43).

4. The metal strip having continuous solderless terminals according to claim 3, wherein the fisheye shaped section (4) includes a V-shaped head (44), a strip-shaped body (45), and a V-shaped tail (46); the upper end of the strip-shaped body (45) is connected to the V-shaped head (44), and the lower end of the strip-shaped body (45) is connected to the V-shaped tail (46) to form the fisheye shaped section (4), the strip-shaped body (45) is along its length direction provided with a tear hole (6) that connects the V-shaped head (44) and V-shaped tail (46); the V-shaped head (44) forms the guiding fisheye head section (41), and the V-shaped tail (46) forms the fisheye tail section (43).

5. The metal strip having continuous solderless terminals according to claim 3, wherein the length of the fisheye shaped section (4) is 2.5+/-0.8mm, the width of the fisheye shaped section (4) is 1.2+/-0.05mm, and the thickness of the fisheye shaped section (4) is 0.635+/-0.04mm.

6. The metal strip having continuous solderless terminals according to claim 3, wherein the length of the guiding fisheye head section (41) is 0.60+/-0.2mm, the length of the fisheye tail section (43) is 0.50+/-0.2mm, and the length of the deformation retaining area section (42) is 1.5+/-0.5mm.

7. The metal strip having continuous solderless terminals (2) according to claim 3, wherein the length of the tear hole (6) is 1.5+/-0.50mm, and the width of the tear hole (6) is 0.2+/-0.10mm.

8. A method for manufacturing a metal strip having continuous solderless terminals as claimed in any one of claims 1-7, including the following steps:
Step 1: Use a square pre-plated copper strip (1) having tin-plated surface and silver-plated bottom;
Step 2: Feed the copper strip (1) into a stamping equipment, which includes a first stamping component for stamping the notch (71) and fisheye shaped section (4), and a second stamping component for trimming the fisheye shaped section (4);
Step 3: The first stamping component stamps fisheye shaped sections (4) and notches (71) along the length direction of the copper strip (1), thereby stamping a plurality of solderless terminals (2) out of the copper strip (1);
Step 4: The second stamping component stamps a tear hole (6) in the direction perpendicular to the fisheye shaped section (4), while the second stamping component adjusts the width of the fisheye shaped section (4) by stamping in the direction parallel to the fisheye shaped section (4), thereby adjusting the shape of the fisheye shaped section (4);
Step 5: Feed the copper strip (1) mentioned in step 4 into the winding device, which rolls the copper strip (1) into the winding shaft (9).

9. A method for inserting solderless terminals of any of the metal strips claimed in claims 1-7 onto a PCB, including the following steps:
Step 1: Feed the metal strip into the device with slitting and pin function, and the device with slitting and pin function will separate the previous solderless terminal (2) and the rear solderless terminal (2);
Step 2: Feed the PCB into a device with slitting and pin insertion function which will insert the solderless terminal (2) into the corresponding jack of the PCB until the fisheye shaped section (4) of the solderless terminal (2) is placed in the jack through interference fit, and the outer wall of the fisheye shaped section (4) is firmly pressed against the inner wall of the jack, and it is ensured that the press-in force and push-out force of the solderless terminal (2) of the device with slitting and pin insertion function do not exceed 150N and 20N, respectively.

10. A PCB using a metal strip having continuous solderless terminals as claimed in any one of claims 1-7, wherein the PCB (8) is provided with a jack (81) with an aperture of 0.90mm to 1.10mm, the guiding head section (3) of the solderless terminal (2) passes through the jack (81), and the fisheye shaped section (4) of the solderless terminal (2) is positioned in the jack (81) through interference fit, and the outer wall of the fisheye shaped section (4) is firmly pressed against the inner wall of the jack (81).
